# FASCICULE DE BREVET EUROPEEN

(11) **EP 1 171 955 B1**
(45) Date de publication et mention de la délivrance du brevet: **05.03.2003**
(21) Numéro de dépôt: 00912742.4
(22) Date de dépôt: 27.03.2000
(51) Int. Cl.: H03M 1/08

(54) **DISPOSITIF DE CONVERSION NUMERIQUE/ANALOGIQUE, PROCEDE DE MISE EN OEUVRE DE CELUI-CI, ET UTILISATION POUR LA REALISATION DE MICROSCOPES A CHAMP PROCHE**
DIGITAL-ANALOG-WANDLER, VERFAHREN ZU DESSEN BETRIEB, UND BENUTZUNG ZUR REALISIERUNG EINES NAHFELDMIKROSKOPS
DIGITAL/ANALOG CONVERSION DEVICE, METHOD FOR THE IMPLEMENTATION THEREOF AND USE THEREOF IN THE PRODUCTION OF NEAR FIELD MICROSCOPES

(30) Priorité: 30.03.1999 FR 9903949
(43) Date de publication de la demande: 16.01.2002
(73) Titulaire: COMMISSARIAT A L'ENERGIE ATOMIQUE, 75752 Paris Cédex 15 (FR)
(72) Inventeur: PHAM VAN, Laurent, F-91940 Les Ulis (FR)
(74) Mandataire: Audier, Philippe André
(86) Numéro de dépôt international: FR0000759
(87) Numéro de publication internationale: WO00060742

(56) Documents cités:
- US-A- 4 016 555
- US-A- 5 138 319
- US-A- 5 815 046
- PATENT ABSTRACTS OF JAPAN vol. 1997, no. 03, 31 mars 1997 (1997-03-31) -& JP 08 298461 A (SHARP CORP), 12 novembre 1996 (1996-11-12)

## Description

### Domaine technique

La présente invention concerne un dispositif de conversion numérique/analogique, permettant la suppression des bruits transitoires de commutation en sortie des convertisseurs numérique/analogique, un procédé de mise en oeuvre de celui-ci, et son utilisation pour la réalisation de microscopes à champ proche.

### Etat de la technique antérieure

La microscopie dite « à champ proche » (en anglais SPM, « Scanning Probe Microscopes ») consiste à balayer une surface à l'aide d'une sonde située à proximité de celle-ci, afin d'en obtenir une image.

Il existe, notamment, trois grandes catégories de microscopes à champ proche qui dépendent du type de sonde utilisée :
- Les microscopes à effet tunnel (en anglais STM), qui reposent sur la mesure du courant tunnel qui circule entre une pointe métallique très fine, et la surface conductrice ou semi-conductrice d'un échantillon ;
- Les microscopes à force atomique (en anglais AFM), qui mesurent la force qui s'exerce entre une pointe et la surface ;
- Les microscopes optiques à champ proche (en anglais SNOM, « Scanning Near Field Optical Microscopy ») qui recueillent ou émettent des photons au moyen d'une fibre optique, dont l'extrémité est taillée en pointe, en exploitant l'effet tunnel optique.

De tels microscopes à champ proche sont devenus d'un usage courant du fait de leurs nombreux avantages : résolution atomique possible, simplicité et faibles dimensions, souplesse du choix de l'environnement de l'échantillon, possibilité d'obtenir, en plus de la topographie, des informations sur des propriétés physiques locales très diverses.

Les microscopes à champ proche sont devenus des instruments de contrôle auxquels on demande de plus en plus de rapidité et de sûreté. Pour atteindre des cadences élevées avec précision, ces microscopes font appel à des contrôleurs électroniques de type numérique. L'utilisation de tels contrôleurs s'impose, en effet, pour leur souplesse, leur précision et leur rapidité face aux systèmes analogiques qui deviennent obsolètes, mais qui jusqu'à présent gardaient l'avantage de présenter peu de bruit. De tels contrôleurs utilisent des convertisseurs numérique/analogique, qui sont des dispositifs destinés à convertir une donnée numérique en une tension, suivant une loi linéaire.

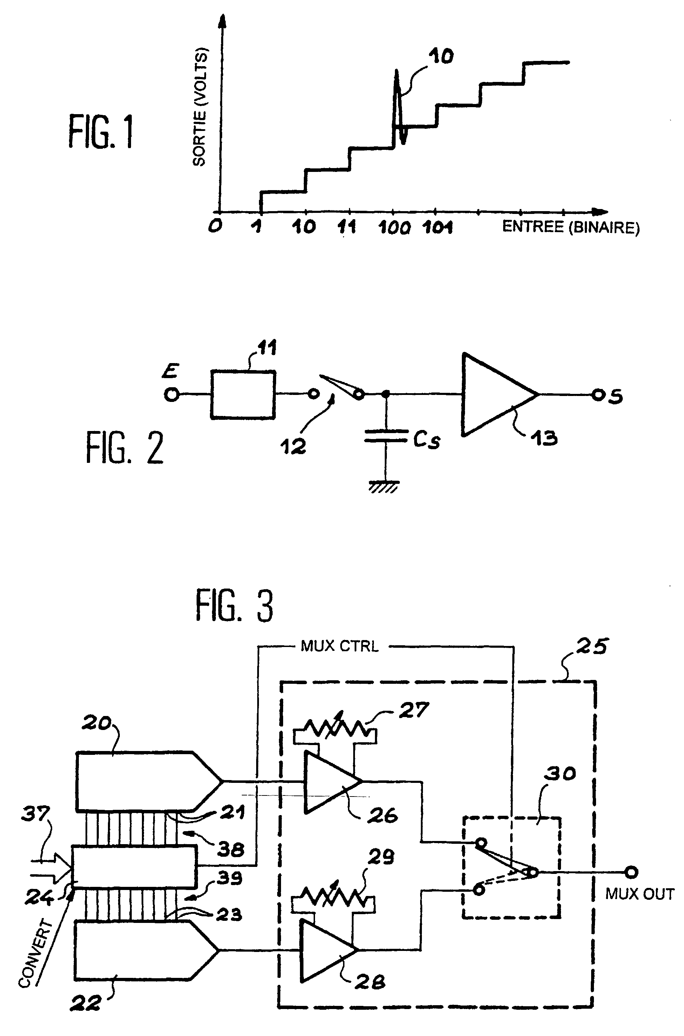

Dans le domaine du contrôle industriel et de l'instrumentation, lorsque l'on exige une bonne linéarité de conversion et une rapidité ultime, on a recours à des convertisseurs traditionnels, dans lesquels chaque bit du mot à convertir commande en tout ou rien une source parmi plusieurs sources de tension parfaitement calibrées. Afin de produire une loi de conversion linéaire, chacune de ces sources présente une tension exactement deux fois plus élevée que la précédente. La tension électrique résultant d'un code numérique donné est obtenue en sommant toutes les tensions. Mais il faut que toutes les tensions sommées soient générées au même instant. Sinon il y a apparition durant l'établissement d'une nouvelle tension en sortie, de transitoires de commutation 10 (« glitches» en anglais) qui, comme illustré sur la figure 1, peuvent atteindre la moitié de l'amplitude totale du signal de sortie du convertisseur.

Différentes solutions ont été mises au point pour résoudre un tel problème :
a) Les solutions au niveau du composant, à savoir :
   a1) Ajuster les retards de chacune des entrées numériques, en se limitant aux bits de poids fort. Une telle solution est loin de résoudre le problème car malgré la qualité de l'ajustement. il subsiste toujours une certaine quantité de transitoires de commutation.
   a2) Réaliser des convertisseurs « sans bruit » constitués de deux convertisseurs intégrés dans le même boîtier, l'un servant à générer les tensions positives, l'autre les tensions négatives. Une telle solution supprime les transitoires de commutation existant autour de la tension correspondant au zéro d'amplitude, mais elle n'apporte aucune amélioration sur le reste de la gamme de tension de sortie du convertisseur.
   a3) Prévoir une possibilité d'ajustement indépendant de la tension de sortie correspondant au bit de poids le plus fort. Une telle solution conduit à améliorer la linéarité autour du zéro d'amplitude, d'où une plus faible distorsion, mais ne contribue pas à supprimer les transitoires de commutation.
   a4) Réaliser des convertisseurs présentant des valeurs de transitoires de commutation très faibles, typiquement dix fois moindre que sur des composants conventionnels. Cette solution réalise un compromis entre rapidité et valeur de transitoires de commutation, mais ne parvient pas à résoudre le problème. Cette technique, surtout utilisée en audiofréquence, a pour principal effet l'amélioration de la réponse au voisinage de zéro volt.
b) Les solutions au niveau du circuit de mise en oeuvre, à savoir :
   b1) Filtrer analogiquement la sortie du convertisseur. Cette solution est imparfaite en terme de précision en tension, car l'énergie électrique qui correspond aux transitoires de commutation se retrouve étalée dans le temps au détriment du délai de stabilisation du convertisseur.
   b2) Ajouter, en sortie du convertisseur 11, un circuit échantillonneur-bloqueur, tel qu'illustré sur la figure 2, qui comprend un dispositif 12 de type interrupteur, un condensateur Cₛ et un amplificateur tampon 13. Un tel circuit permet dans un premier temps de mémoriser (échantillonnage) la tension générée par le convertisseur puis de présenter cette tension en sortie (blocage). Mais, il faut alors faire un compromis sur la valeur de la capacité du condensateur Cₛ : pour maintenir, pendant la phase de blocage, une sortie stable dans le temps et compatible avec la précision du convertisseur, la capacité doit être de valeur élevée. Mais plus cette capacité est élevée, plus elle est longue à charger, ce qui nuit à la précision du convertisseur.

Aucune de ces solutions ne permet donc de supprimer totalement les transitoires de commutation sur toute la plage de tension de sortie du convertisseur numérique/analogique en conservant les avantages de celui-ci, à savoir sa précision et sa rapidité.

L'invention a pour objet de proposer un dispositif de conversion numérique/analogique permettant de résoudre un tel problème.

Un premier document de l'art antérieur, le brevet US 4 016 555, décrit un convertisseur numérique/analogique permettant d'obtenir des taux de résolution net de conversion élevés en réalisant simultanément un traitement parallèle des bits d'informations grossiers et des bits d'information fins d'une entrée binaire.

Un second document de l'art antérieur, l'abrégé japonais Patent Abstracts of Japan vol. 1997, N° 03, 31 mars 1997 (1997-03-31)-& JP 08 298 461 A (SHARP Corp). 12 novembre 1996 (1996-11-12) divulgue un dispositif qui commute alternativement deux convertisseurs dans le but d'éviter les parasites de commutation, cette commutation s'effectuant systématiquement, à une cadence régulière, préétablie.

Un troisième document de l'art antérieur, le brevet US 5 815 046, décrit un modulateur numérique accordable qui comprend deux convertisseurs numérique/analogique identiques multiplexés et alternés. permettant de réduire les composantes de fréquence parasites en sortie. On alterne-ces deux convertisseurs numérique/analogique à l'aide d'un commutateur d'entrée et d'un commutateur de sortie, en produisant le signal de sortie analogique modulé.

### Exposé de l'invention

La présente invention concerne un procédé de mise en oeuvre d'un dispositif de conversion numérique analogique comprenant deux convertisseurs numérique/analogique, un dispositif de traitement des sorties de ces deux convertisseurs comprenant des moyens de sélection d'un convertisseur pour sortir le signal issu du convertisseur sélectionné, caractérisé en ce que, le dispositif de traitement comprenant en outre des moyens associés d'obtention de lois de conversion identiques mesurées en sortie pour une même grandeur en entrée, que ce soit l'un ou l'autre des deux convertisseurs qui ait été mis en oeuvre, et le dispositif de conversion comprenant un dispositif numérique de contrôle qui reçoit une entrée de N bits et qui délivre d'une part deux sorties respectives de N bits en parallèles dirigées respectivement vers les entrées numériques des deux convertisseurs et d'autre part un signal de commande des moyens de sélection de manière à masquer la transition du convertisseur non sélectionné, ledit procédé est tel que, les deux convertisseurs ayant tout d'abord une même valeur numérique en entrée, avec la sortie du premier convertisseur sélectionnée, lorsque l'on désire modifier la valeur numérique :
(a) on envoie une nouvelle valeur numérique E(n) en entrée du second convertisseur, on commande alors le dispositif pour que la sortie du second convertisseur soit sélectionnée, une fois écoulé le temps de stabilisation de la sortie de celui-ci ;
(b) on envoie ensuite la valeur numérique E(n) à l'entrée du premier convertisseur, on commande ensuite le dispositif de traitement pour sélectionner la sortie du premier convertisseur, une fois écoulé le temps de stabilisation de la sortie de celui-ci ;
et dans lequel on peut recommencer en (a).

Avantageusement, la sélection entre les convertisseurs est déclenchée par l'arrivée d'un nouvel échantillon E(n).

Le procédé de l'invention peut être utilisé pour la mise en oeuvre d'un positionnement de précision pour le pilotage des microscopes à champ proches, et de la réalisation de masques de lithographie à l'échelle du nanomètre pour la fabrication des microcircuits électroniques.

Mais il permet également de réduire la distorsion de générateurs rapides de précision, par exemple pour des applications de détection synchrone, dans le cas de génération de fonction de formes aléatoires. Il peut s'avérer utile dans le domaine de l'électrochimie où des sources de tension pilotables et sans transitoire de commutation parasite sont nécessaires. Il devrait également trouver des applications dans le domaine médical et en robotique, pour le contrôle d'actionneurs analogiques.

### Brève description des dessins

- La figure 1 illustre la fonction idéale d'un convertisseur numérique/analogique perturbée par transitoire de commutation ;
- la figure 2 illustre le principe d'un échantillonneur-bloqueur placé à la sortie du convertisseur ;
- la figure 3 illustre le dispositif de l'invention ;
- la figure 4 illustre un exemple de réalisation d'un dispositif numérique de contrôle du dispositif de l'invention ;
- la figure 5 illustre le fonctionnement de l'exemple de réalisation illustré sur la figure 4.

### Exposé détaillé de modes de réalisation

Le dispositif de conversion numérique/analogique de l'invention, tel que représenté sur la figure 3, comprend deux convertisseurs numérique/analogique 20 et 22 avec des entrées numériques respectives 21 et 23 délivrées par un dispositif numérique 24 de contrôle de ces convertisseurs, et un dispositif 25 de traitement des sorties de ces convertisseurs comprenant des moyens de sélection entre l'une ou l'autre des sorties des convertisseurs 20 et 22 pour l'envoyer en sortie, afin de masquer la transition du convertisseur non sélectionné, et deux amplificateurs opérationnels 26 et 28, reliés respectivement à la sortie de chacun des deux convertisseurs 20 et 22, le gain et la tension de décalage (« offset ») de ces amplificateurs 26 et 28 étant contrôlés par un ajustement fin (les potentiomètres, respectivement 27 et 29, permettant l'ajustement du gain), et les sorties de ces amplificateurs étant reliées aux entrées d'un commutateur électronique 30 très rapide, par exemple un multiplexeur vidéo.

Ce dispositif de traitement 25 a ainsi pour objet de permettre deux modes de fonctionnement.

Dans un premier mode de fonctionnement, lorsque l'on veut changer la valeur de sortie du dispositif, le premier convertisseur 20, avec une valeur numérique donnée en entrée, étant alors connecté en sortie, on applique une nouvelle valeur numérique E(n) au second convertisseur 22. On commande alors le dispositif de traitement 25 pour que la sortie de ce second convertisseur 22 soit sélectionnée, une fois le temps de stabilisation de la sortie de ce second convertisseur 22 écoulé. En sortie du dispositif de traitement 25 on dispose alors de la tension correspondant à la nouvelle valeur numérique E(n). Si l'on désire changer, à nouveau, la valeur de sortie, on applique une nouvelle valeur numérique E(n+1) à l'entrée du premier convertisseur 20. On commande alors le dispositif de traitement 25 pour que la sortie de ce premier convertisseur 20 soit sélectionnée, une fois le temps de stabilisation de la sortie de ce premier convertisseur 20 écoulé. On recommence ensuite, si nécessaire, le même processus.

Dans un second mode de fonctionnement, les deux convertisseurs 20 et 22 on tout d'abord la même valeur numérique en entrée. Si la sortie du premier convertisseur 20 est sélectionnée, lorsque l'on désire modifier la valeur numérique, on envoie la nouvelle valeur numérique E(n) en entrée du second convertisseur 22. On commande alors le dispositif de traitement 25 pour que la sortie du second convertisseur 22 soit sélectionnée, une fois le temps de stabilisation de la sortie de ce second convertisseur 22 écoulé. On envoie ensuite cette valeur numérique E(n) à l'entrée du premier convertisseur 20. On commande ensuite le dispositif de traitement 25 pour sélectionner la sortie du premier convertisseur 20, une fois le temps de stabilisation de la sortie de ce premier convertisseur écoulé. On recommence ensuite, si nécessaire, le même processus.

Dans le premier mode de fonctionnement, on sélectionne la sortie d'un premier convertisseur afin de l'envoyer en sortie et de masquer ainsi la transition au second convertisseur non sélectionné. On peut changer de valeur numérique d'entrée avec des intervalles minimaux valant une fois le temps de stabilisation.

Dans le second mode de fonctionnement, c'est toutes les deux fois le temps de stabilisation que peut intervenir le changement de valeur numérique. En pratique, ce deuxième mode peut avantageusement être choisi lorsqu'il est difficile d'obtenir des lois de transfert identiques, à la précision désirée, pour les deux convertisseurs, notamment en cas de forts écarts de linéarité entre ceux-ci.

En définitive, ces deux modes de fonctionnement permettent l'élimination totale des transitoires de commutation des convertisseurs, en conservant la précision de ceux-ci, et en maintenant des cadences de conversion équivalentes ou supérieures à celles de toutes les solutions envisagées précédemment.

Dans l'exemple de réalisation, illustré sur la figure 3, les deux convertisseurs 20 et 21 sont des convertisseurs de 16 bits de résolution.

Le dispositif numérique 24 de contrôle des deux convertisseurs 20 et 22 et du multiplexeur 30 peut être assuré par un ensemble de circuits logiques ou par un circuit logique programmable (PAL, FPGA etc.).

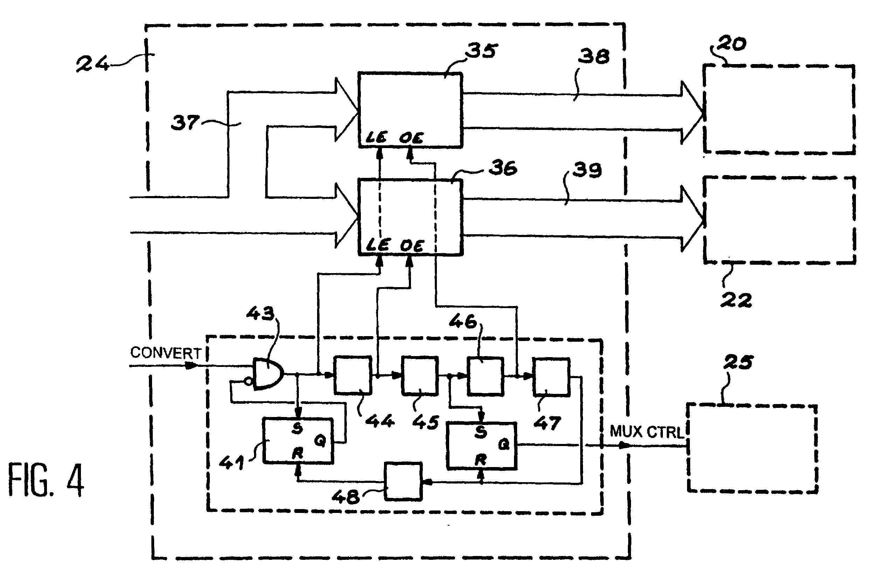

La figure 4 représente schématiquement un exemple de réalisation de ce dispositif numérique de contrôle 24 dans le cas du second mode de fonctionnement, le rôle de ce système étant de présenter les valeurs numériques à convertir en entrée des deux convertisseurs 20 et 22 et de commuter le multiplexeur 30 en respectant les chronologies imposées par les composants utilisés, notamment les délais nécessaires à la conversion numérique/analogique.

Ce système comprend deux verrous 35 et 36 recevant une entrée 37 de N bits en parallèle et délivrant deux sorties respectives 38 et 39 de N bits en parallèle dirigées respectivement vers les entrées numériques 21 et 23 des deux convertisseurs 20 et 22. Elle comporte également deux bascules 41 et 42, et en série en sortie Q de la première 41 de ces deux bascules une entrée inverseuse d'une porte ET à deux entrées 43, dont la seconde entrée reçoit un signal d'écriture « convert », cinq circuits retards 44, 45, 46, 47 et 48 de retards respectifs d1, d2, d3, d4 et d5. La sortie de la porte ET 43 est reliée à l'entrée « Latch Enable » des deux verrous 35 et 36 et à l'entrée « Set » de la première bascule 41. La sortie du premier circuit retard 44 est reliée à l'entrée « Output Enable » du second verrou 36. La sortie du second circuit retard 45 est reliée à l'entrée « Set » de la seconde bascule 42. La sortie du troisième circuit retard 46 est reliée à l'entrée « Output Enable» du premier verrou 35. La sortie du quatrième circuit retard 47 est reliée à l'entrée « Reset » de la seconde bascule 42. La sortie du cinquième circuit retard 48 est reliée à l'entrée « Reset » de la première bascule 41. La sortie de la seconde bascule délivre le signal « MuxCtrl » dirigée vers l'entrée du multiplexeur 25.

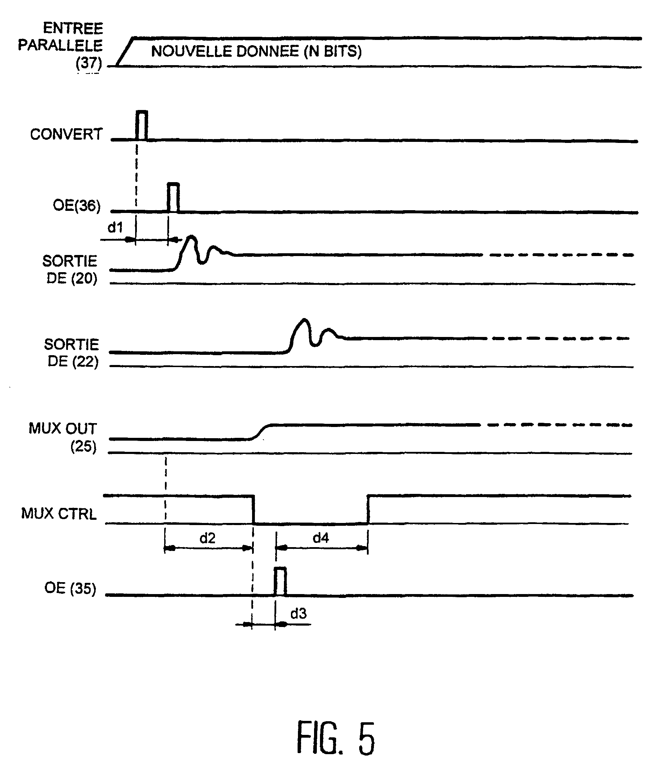

Une fois que la valeur numérique à convertir est présente en entrée 37 des deux verrous 35 et 36, l'ordre d'écriture « Convert » active le chargement des deux verrous 35 et 36 et active la sortie de la première bascule 41 qui permet de ne plus prendre en compte de nouvel ordre de conversion. Passé le premier délai d1, correspondant au temps de chargement des verrous, le second verrou 36, activé par son entrée « Output Enable », présente son contenu à l'entrée du second convertisseur 22. Passé le second délai d2, correspondant à la durée de conversion du second convertisseur 22, la seconde bascule 42 est activée, via son entrée « Set », afin que le multiplexeur 25 commute sur la sortie du second convertisseur 22. Passé le troisième délai d3, correspondant à la durée de commutation du multiplexeur 25, le premier verrou 35 reçoit l'ordre, via son entrée « Output Enable », de présenter son contenu au premier convertisseur 20. Passé le quatrième délai d4, correspondant à la durée de conversion du premier convertisseur 20, la seconde bascule 42 est désactivée, via son entrée « Reset », et le multiplexeur 25 rebascule sur la sortie du premier convertisseur 20. Passé le cinquième délai d5, correspondant à la durée de commutation du multiplexeur 25, la première bascule 41 est désactivée, via son entrée « Reset », ce qui permet la prise en compte d'un nouvel ordre de conversion. Un chronogramme correspondant au second mode de fonctionnement décrit ci-dessus, est représenté à la figure 5.

## Revendications

1. Procédé de mise en oeuvre d'un dispositif de conversion numérique/analogique comprenant deux convertisseurs numérique/analogique (20, 22), un dispositif (25) de traitement des sorties de ces deux convertisseurs (20, 22) comprenant des moyens de sélection (30) d'un convertisseur pour sortir le signal issu du convertisseur sélectionné, **caractérisé en ce que**, le dispositif (25) de traitement comprenant en outre des moyens associés d'obtention de lois de conversion identiques mesurées en sortie pour une même grandeur en entrée, que ce soit l'un ou l'autre des deux convertisseurs qui ait été mis en oeuvre, et le dispositif de conversion comprenant un dispositif numérique de contrôle (24) qui reçoit une entrée de N bits (37) et qui délivre d'une part deux sorties respectives de N bits en parallèles (38, 39) dirigées respectivement vers les entrées numériques (21, 23) des deux convertisseurs (20, 22) et d'autre part un signal («MUXCTRL») de commande des moyens de sélection (30) de manière à masquer la transition du convertisseur non sélectionné, ledit procédé est tel que, les deux convertisseurs (20, 22) ayant tout d'abord une même valeur numérique en entrée, avec la sortie du premier convertisseur (20) sélectionnée, lorsque l'on désire modifier la valeur numérique :
(a) on envoie une nouvelle valeur numérique E(n) en entrée du second convertisseur (22), on commande alors le dispositif (25) pour que la sortie du second convertisseur (22) soit sélectionnée, une fois écoulé le temps de stabilisation de la sortie de celui-ci ;
(b) on envoie ensuite la valeur numérique E(n) à l'entrée du premier convertisseur (20), on commande ensuite le dispositif de traitement (25) pour sélectionner la sortie du premier convertisseur (20), une fois écoulé le temps de stabilisation de la sortie de celui-ci ;
et dans lequel on peut recommencer en (a).

2. Procédé selon la revendication 1, dans lequel la sélection entre les convertisseurs est déclenchée par l'arrivée d'un nouvel échantillon E(n).

3. Utilisation du procédé selon la revendication 1, pour la mise en oeuvre de microscopes à champ proche.

## Claims

1. Method for the implementation of a digital/analogue conversion device, comprising two digital/analogue converters (20, 22), a device (25) for processing the output of these two converters (20, 22) comprising converter selection means (30) to produce the signal from the selected converter, **characterised in that** the processing device (25) furthermore comprises associated means, for obtaining identical conversion laws measured at the output for the same magnitude at the input, whether it be one or other of the two converters which has been implemented, and the conversion device comprises a digital control device (24) which receives an input of N bits (37) and which firstly delivers two respective outputs of N bits in parallel (38, 39) directed respectively to the digital outputs (21, 23) of the two converters (20, 22) and secondly a signal ("MUXCTRL") for controlling the selection means (30) in such a way as to conceal the transition of the non-selected converter, the said method is such that with both converters (20, 22) having the same digital input value, and with the output of the first converter (20) being selected, when one wishes to modify the digital value :
a) a new digital value E(n) is sent to the input of the second converter (22), the device (25) is thus controlled so that the output of the second converter (22) is selected once enough time has elapsed for the output of the latter to be stabilised;
b) the digital value E(n) is then sent to the input of the first converter (2), the processing device (25) is then controlled for selecting the output of the first converter (20), once enough time has elapsed for the output of the latter to be stabilised;
and one can thus recommence at (a).

2. Method according to claim 1, in which the selection of converters is initiated by the arrival of a new sample E(n).

3. Use of the method according to claim 1, for the implementation of near field microscopes.

## Patentansprüche

1. Verfahren zur Anwendung einer Digital-/Analog-Wandlervorrichtung mit zwei Digital-/Analog-Wandlern (20, 22), einer Vorrichtung (25) zur Verarbeitung der Ausgangssignale dieser beiden Wandler (20,22) mit Mitteln zur Auswahl (30) eines Wandlers zum Ausgeben des von dem ausgewählten Wandler kommenden Signals, **dadurch gekennzeichnet, dass** die Verarbeitungsvorrichtung (25) außerdem zugeordnete Mittel zum Erhalt identischer Umwandlungsregeln, die am Ausgang für eine gleiche Größe am Eingang gemessen werden, gleichgültig, ob es der eine oder der andere der beiden Wandler ist, der verwendet wurde, aufweist, und die Wandlervorrichtung eine digitale Steuervorrichtung (24), welche eine Eingangsgröße von N Bits (37) empfängt und einerseits zwei betreffende Ausgangssignale von N Bits (38,39) parallel liefert, die jeweils zu den digitalen Eingängen (21,23) der beiden Wandler (20,22) geleitet werden, und andererseits ein Signal ("MUXCTRL") zur Steuerung der Auswahlmittel (30) so liefert, dass sie den Übergang des nicht-ausgewählten Wandlers maskieren, aufweist, wobei das Verfahren derart abläuft, dass bei zunächst einem gleichen digitalen Wert am Eingang der beiden Wandler (20, 22) bei ausgewähltem Ausgang des ersten Wandlers (20), wenn eine Veränderung des digitalen Werts gewünscht wird:
(a) ein neuer digitaler Wert E(n) zum Eingang des zweiten Wandlers (22) geschickt wird, und dann die Vorrichtung (25) so gesteuert wird, dass der Ausgang des zweiten Wandlers (22) ausgewählt wird, sobald die Stabilisierungszeit von dessen Ausgang verstrichen ist,
(b) anschließend der digitale Wert E(n) zum Eingang des ersten Wandlers (20) geschickt wird, und dann die Verarbeitungsvorrichtung (25) so gesteuert wird, dass sie den Ausgang des ersten Wandlers (20) auswählt, sobald die Stabilisierungszeit von dessen Ausgang verstrichen ist,
und wobei bei (a) von neuem begonnen werden kann.

2. Verfahren nach Anspruch 1, wobei die Auswahl zwischen den Wandlern durch die Ankunft eines neuen Abtastwerts E(n) ausgelöst wird.

3. Verwendung des Verfahrens nach Anspruch 1 für den Einsatz von Nahfeld-Mikroskopen.
